## Europäisches Patentamt

## European Patent Office

## Office européen des brevets

(11) Veröffentlichungsnummer: **0 011 736**

**A1**

(12) **EUROPÄISCHE PATENTANMELDUNG**

(21) Anmeldenummer: 79104337.5

(22) Anmeldetag: 06.11.79

(51) Int. Cl.³: **H 03 L 7/06**
**B 60 T 8/00**

(30) Priorität: 30.11.78 DE 2851819

(43) Veröffentlichungstag der Anmeldung:
11.06.80 Patentblatt 80/12

(84) Benannte Vertragsstaaten:
CH FR GB IT SE

(71) Anmelder: **Knorr-Bremse GmbH**
**Moosacher Strasse 80**
**D-8000 München 40(DE)**

(72) Erfinder: **Schirmer, Klaus**
**Mitterweg 14**
**D-8031 Olching(DE)**

(54) Vorrichtung zur Aufbereitung von Eingangssignalen von Blockierschutzeinrichtungen.

(57) Die Vorrichtung zur Aufbereitung von Eingangssignalen von Blockierschutzeinrichtungen weist eine phasenstarre Schleife bzw. Phasenregelkreis mit einem Phasenvergleicher (2) zum Vergleichen der Phasen eines Eingangs- (fx) und eines Rückführsignals (f'x), einem vom Ausgangssignal des Phasenvergleichers (2) spannungsgesteuerten Oszillator (4), einem Frequenzteiler (5), dessen Eingang mit dem Ausgang des Oszillators (4) und dessen Ausgang mit dem Eingang des Phasenvergleichers (2) verbunden ist, und einen zwischen den Ausgang des Phasenvergleichers (2) und den Eingang des Oszillators (4) eingeordneten Tiefpaß (3) auf.

Durch entsprechende Auslegung des Tiefpasses (3) ist eine elektronische "Schwungradcharakteristik" der einfachen, aus wenigen handel süblichen Baugruppen aufbauba- ren und gut an die jeweiligen Bedingungen anpaßbaren Vor- richtung erreichbar.

München, 16.11.1978
TP1-DrvBü/so
- 1536 -

Vorrichtung zur Aufbereitung von
Eingangssignalen von Blockierschutzeinrichtungen

---

Die Erfindung bezieht sich auf eine Vorrichtung zur Aufbereitung von Eingangssignalen von Blockierschutzeinrichtungen unter
Verwendung einer "phasenstarren Schleife" mit einem Phasenvergleicher, einem spannungsgesteuerten Oszillator und einem Frequenzteiler in der Rückführung.

Phasenstarre Schleifen bzw. Phasenregelkreise sind an sich bekannt und enthalten einen Phasenvergleicher, der die Phasen
eines Eingangssignales und eines Rückführungssignales miteinander vergleicht. Das Ausgangssignal des Phasenvergleichers ist
der Phasendifferenz der beiden Eingangssignale proportional.
Dieses Ausgangssignal steuert einen spannungsgesteuerten Oszillator, dessen Ausgangssignal über einen Frequenzteiler dem einen
Eingang des Phasenvergleichers zugeführt wird. Die Frequenz
des spannungsgesteuerten Oszillators ist damit um den Faktor
des Frequenzteilers höher als die Eingangsfrequenz der phasenstarren Schleife. Die phasenstarre Schleife ist damit zur
Frequenzvervielfachung geeignet.

- 2 -

Bei digitalen Blockierschutzeinrichtungen ist eine Frequenzvervielfachung des von einem mit dem überwachten Rad gekuppelten
Frequenzgenerator gelieferten Signales nützlich, wenn dieses
Signal digital weiter verarbeitet werden soll.

Aus der DE-OS 26 23 114 ist eine phasenstarre Schleife bekanntgeworden, bei der ein Systemtaktgenerator mit fester und gegenüber der Eingangsfrequenz hoher Frequenz eine Phasenvergleichsstufe und zwei Eingangsschaltungen zur Synchronisierung der
Eingangssignale für die Phasenvergleichsstufe taktet. Das Ausgangssignal der Phasenvergleichsstufe wird einem Regler zugeführt, dessen Ausgangssignal das Ausgangssignal der phasenstarren
Schleife darstellt und das über einen Untersetzer der Phasenvergleichsstufe eingangsseitig rückgeführt wird. Nachteilig hieran
ist, daß die Impulsbreite der Schaltung durch den genannten
Taktgenerator vorgegeben ist und daß die Schaltung noch relativ
viele Bauelemente benötigt.

Aufgabe der vorliegenden Erfindung ist es daher, eine Vorrichtung der oben genannten Art dahingehend zu verbessern, daß sie
bei vereinfachtem Aufbau ein sicheres Arbeiten gewährleistet
und dabei in ihrem dynamischen Verhalten an die jeweiligen, geforderten Bedingungen anpassbar ist.

- 3 -

Diese Aufgabe wird dadurch gelöst, daß zwischen dem Ausgang
des Phasenvergleichers und dem Eingang des spannungsgesteuerten
Oszillators ein Tiefpaß vorgesehen ist.

Hierdurch wird erreicht, daß - je nach Auslegung des Tiefpasses -
eine elektronische "Schwungradcharakterisitik" erhalten wird,
und daß ein Konstantfrequenzgenerator sowie eine Eingangsschaltung für die Symmetrierung des Eingangssignales der Schaltung
eingespart wird.

Vorteilhafte Ausgestaltungen und Weiterbildungen der Erfindung
sind den Unteransprüchen zu entnehmen.

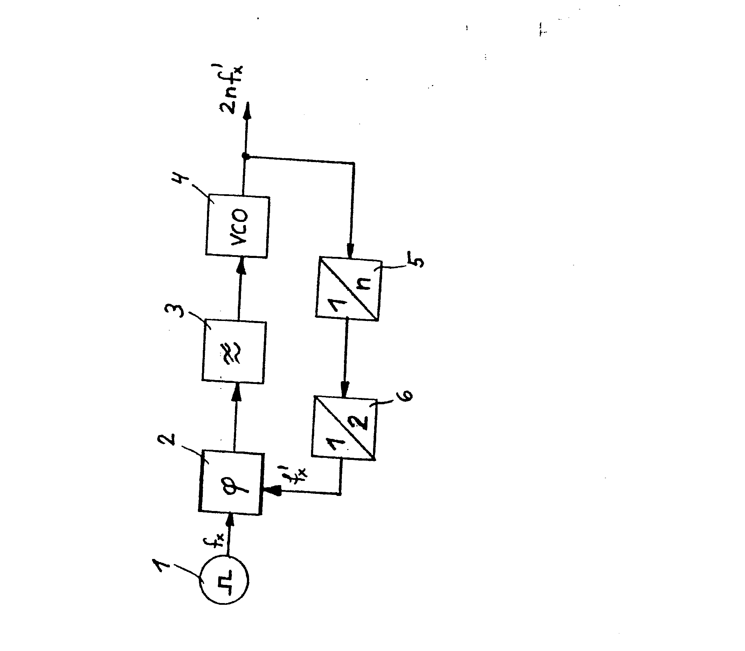

Im Folgenden wird die Erfindung anhand eines Ausführungsbeispieles im Zusammenhang mit der einzigen Figur erläutert.

Diese Figur zeigt ein Blockschaltbild der erfindungsgemäßen Vorrichtung. Ein mit der Achse des überwachten Rades gekoppelter
Radsensor 1 liefert drehzahlproportionale Signale mit einer
Frequenz $f_x$ zu einem Eingang eines Phasenvergleichers 2. Der
Ausgang des Phasenvergleichers 2 ist über einen Tiefpaß 3 mit
dem Eingang eines spannungsgesteuerten Oszillators 4 verbunden.
Der Ausgang des spannungsgesteuerten Oszillators 4 liefert das
Ausgangsignal der Vorrichtung. Dieses Ausgangsignal wird einem
ersten Frequenzteiler 5 zugeführt und dort um einen Faktor n

- 4 -

heruntergeteilt. Das Ausgangssignal dieses Teilers 5 wird einem
Symmetrierteiler 6 zugeführt und dort durch den Faktor 2 geteilt. Das Ausgangssignal des Symmetrierteilers 6 wird dem zweiten Eingang des Phasenvergleichers 2 zugeführt. Dieses Signal
weist eine mit $f_x'$ bezeichnete Frequenz auf. Damit ist die
phasenstarre Schleife geschlossen.

Die Wirkungsweise der Vorrichtung ist wie folgt:

Die von dem Radsensor 1 gelieferte Frequenz $f_x$ wird in dem
Phasenvergleicher mit der rückgeführten Frequenz $f_x'$ hinsichtlich Phasenlage und Frequenz verglichen. Der Phasenvergleicher
2 liefert an seinem Ausgang Gleichspannungsimpulse, die in
Polarität und Dauer von der Phasendifferenz der Eingangssignale
abhängen. In dem nachfolgenden Tiefpaß 3 werden diese Gleichspannungsimpulse zu einer Gleichspannung geglättet, die als
Steuerspannung für den spannungsgesteuerten Oszillator 4 dient.
Der Tiefpaß ist entsprechend dem gewünschten Einschwingverhalten des Systems bemessen.

Der Oszillator 4 liefert die Ausgangsfrequenz $2nf_x'$, die in dem
Frequenzteiler 5 mit dem wählbaren Teilerfaktor durch "n" geteilt wird. In dem Symmetrierteiler 6 wird die Ausgangsfrequenz
des Frequenzteilers 5 noch einmal durch "2" geteilt, so daß der
Symmetrierteiler 6 dem Phasenvergleicher 2 ein tastsymmetrisches
Eingangssignal mit der Frequenz $f_x'$ zur Verfügung stellt.

Durch die Rückkopplung ist - nach Maßgabe des Einschwingverhaltens, insbesondere des Tiefpaßes 3 - auch sichergestellt,
daß $f_x = f'_x$ ist. Da die Frequenz des spannungsgesteuerten Oszillators 4 aber $2nf'_x$ beträgt, folgt, daß die Ausgangsfrequenz
"2n" mal höher frequent als die Eingangsfrequenz ist und zwar
mit phasenstarrer Kopplung. Je nach Wahl des Teilerfaktors des
Frequenzteilers 5 lassen sich Frequenzvervielfachungen bis etwa
zum Faktor mal 20 in einer Schleife realisieren.

Durch Wahl des Teilerfaktors n lässt sich eine stufenweise Anpassung an unterschiedliche Raddurchmesser vornehmen, so daß sich
auch bei unterschiedlichen Raddurchmessern bei gleicher Geschwindigkeit auch die gleiche Ausgangsfrequenz einstellen lässt.

Der Tiefpaß 3 kann so ausgelegt werden, daß dessen Ausgangsfrequenz in ihrer Änderungsgeschwindigkeit beschränkt ist, woraus
sich die eingangs genannte Schwungradcharakteristik für die erfindungsgemäße Vorrichtung ergibt.

Da die einzelnen verwendeten Baugruppen, wie Phasenvergleicher,
Tiefpaß, spannungsgesteuerter Oszillator, Frequenzteiler und
Symmetrierteiler allgemein bekannte und im Handel erhältliche
Bauteile sind, kann auf eine detaillierte Beschreibung des
Aufbaues dieser Bauteile verzichtet werden. Dem Fachmann sind diese Bauteile jeweils für sich bekannt.

Alle in der Beschreibung erwähnten und mit der Figur dargestellten technischen Einzelheiten sind für die Erfindung von Bedeutung.

München, 16.11.1978
TP1-DrvBü/so
- 1536 -

K N O R R - B R E M S E

G.m.b.H.

Moosacher Straße 80

8000  M ü n c h e n  40


P a t e n t a n s p r ü c h e


1. Vorrichtung zur Aufbereitung von Eingangssignalen von Blockierschutzeinrichtungen unter Verwendung einer "phasenstarren Schleife" mit einem Phasenvergleicher, einem spannungsgesteuerten Oszillator und einem Frequenzteiler in der Rückführung, dadurch gekennzeichnet, daß zwischen dem Ausgang des Phasenvergleichers (2) und dem Eingang des spannungsgesteuerten Oszillators (4) ein Tiefpaß (3) vorgesehen ist.


2. Vorrichtung nach Anspruch 1, dadurch gekennzeichnet, daß in der Rückführung zusätzlich ein Symmetrierteiler (6) mit tastsymmetrischem Ausgangssignal vorgesehen ist.


3. Vorrichtung nach Anspruch 1, dadurch gekennzeichnet, daß das Teilerverhältnis (n) des Teilers (5) einstellbar ist.


- 2 -

– 2 –

4. Vorrichtung nach Anspruch 2, dadurch gekennzeichnet, daß das Teilerverhältnis des Symmetrierteilers (6) konstant ist.

5. Vorrichtung nach Anspruch 1, dadurch gekennzeichnet, daß die Übertragungsfunktion des Tiefpaßes (3) einstellbar ist.

**EUROPÄISCHER RECHERCHENBERICHT**

Europäisches
Patentamt

| | EINSCHLÄGIGE DOKUMENTE | | KLASSIFIKATION DER ANMELDUNG (Int.Cl.²) |
|---|---|---|---|
| Kategorie | Kennzeichnung des Dokuments mit Angabe, soweit erforderlich, der maßgeblichen Teile | betrifft Anspruch | |
| X | US - A - 3 898 690 (DESAI)<br><br>⁜ Spalte 1, Zeile 43 - Spalte 4, Zeile 20; Figuren ⁜ | 1-4 | H 03 L 7/06<br>B 60 T 8/00 |
| X | ELECTRONIC DESIGN, Band 24, Nr. 11, 24. Mai 1976, Rochelle Park, US, ZWICKER: "Phase-locked-loop circuit multiplies frequencies by 2 to 256", Seite 94<br><br>⁜ Seite 94 ⁜ | 1-5 | |
| X | DE - A - 2 238 241 (BOSCH)<br><br>⁜ Seite 1, Zeilen 3-11; Seite 2, Zeile 18 - Seite 23, Zeile 18; Ansprüche 1,2; Figuren 1a,2,3a, 3c,4a ⁜ | 1 | RECHERCHIERTE SACHGEBIETE (Int. Cl.²)<br><br>H 03 L 7/06<br>7/18 |
| X | FR - A - 2 296 962 (RENAULT et al)<br><br>⁜ Seite 2, Zeile 12 - Seite 5, Zeile 9; Ansprüche 1,2; Figuren 1,3 ⁜ | 1 | |
| X | DE - A - 2 504 462 (BOSCH)<br><br>⁜ Seite 1, Zeile 1 - Seite 3, Zeile 26; Figur ⁜ | 1 | |
| X | DE - A - 1 591 994 (ROHDE & SCHWARZ)<br><br>⁜ Ansprüche 1-3; Seite 1, Zeile 17 - Seite 9, Zeile 3; Figuren 1,2 ⁜ | 1,3 | |

./.

**KATEGORIE DER GENANNTEN DOKUMENTE**

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 29-02-1980 | DHONDT |

EPA form 1503.1  06.78

**Europäisches Patentamt**

# EUROPÄISCHER RECHERCHENBERICHT

| | EINSCHLÄGIGE DOKUMENTE | | | KLASSIFIKATION DER ANMELDUNG (Int.Cl. 3) |
|---|---|---|---|---|
| Kategorie | Kennzeichnung des Dokuments mit Angabe, soweit erforderlich, der maßgeblichen Teile | betrifft Anspruch | | |
| | DE - B - 1 762 025 (FERNSEH) <br><br> * Seite 1, Zeile 1 - Seite 4, Zeile 2; Ansprüche 1,2 * | 1,5 | | |
| | | | | RECHERCHIERTE SACHGEBIETE (Int. Cl. 3) |

EPA Form 1503.2  06.78